# EUROPÄISCHE PATENTSCHRIFT

(11) **EP 1 397 525 B1**
(45) Veröffentlichungstag und Bekanntmachung des Hinweises auf die Patenterteilung: **01.03.2006**
(21) Anmeldenummer: 02743190.7
(22) Anmeldetag: 13.06.2002
(51) Int. Cl.: C23C 14/32, C23C 14/56

(54) **EINRICHTUNG ZUR PLASMAAKTIVIERTEN BEDAMPFUNG GROSSER FLÄCHEN**
DEVICE FOR VACUUM METALLISING LARGE SURFACES BY PLASMA ACTIVATION
DISPOSITIF POUR METTRE EN OEUVRE UNE METALLISATION SOUS VIDE ACTIVEE PAR PLASMA SUR DE GRANDES SURFACES

(30) Priorität: 19.06.2001 DE 10129507
(43) Veröffentlichungstag der Anmeldung: 17.03.2004
(73) Patentinhaber: Fraunhofer-Gesellschaft zur Förderung der angewandten Forschung e.V., 80686 München (DE)
(72) Erfinder: NEUMANN, Manfred, 01217 Dresden (DE); STRAACH, Steffen, 01187 Dresden (DE); KRUG, Mario, 08144 Neustadt/Sachsen (DE); SCHILLER, Nicolas, 01833 Stolpen, OT Helmsdorf (DE)
(86) Internationale Anmeldenummer: PCT/EP2002/006505
(87) Internationale Veröffentlichungsnummer: WO 2002/103077

(56) Entgegenhaltungen:
- EP-A- 0 887 433
- DE-C- 10 018 639
- DE-C- 19 612 344
- DE-C- 19 612 345
- US-A- 3 898 952
- US-A- 5 580 386

## Beschreibung

Die Erfindung betrifft eine Einrichtung zur plasmaaktivierten Bedampfung großer Flächen mit hohen Beschichtungsraten. Die zu beschichtenden großflächigen Substrate können Platten aus Kunststoff, Glas oder Metall oder auch bandförmige Materialien wie Kunststofffolien, vorbeschichtete Papiere oder Textilien sowie auf Transportrahmen angeordnete Formkörper sein. Typische Anwendungen sind das Auftragen reflektierender, reflexmindernder oder dekorativer Schichten sowie das Erzeugen von Abriebschutz-, Korrosionsschutz- oder Barriereschichten. In den meisten Fällen sind fest haftende Schichten hoher Dichte erforderlich, die nur mit Hilfe plasmaaktivierter Prozesse abgeschieden werden können. Bei hohen Bedampfungsraten sind entsprechend hohe Plasmadichten erforderlich, um die gewünschten Wirkungen der Plasmaaktivierung zu erzielen.

Es ist bekannt, eine Umlenkrolle einer Bandbedampfungsanlage gleichzeitig als Permanentmagnet und als Kathode eines Glimmentladungsplasma erzeugenden Mittels auszubilden, um ein Plasma zu erzeugen, welches sich über die gesamte Breite eines zu beschichtenden Substrates erstreckt (US 3,898,952). Mit einem Glimmentladungsplasma lassen sich jedoch nur verhältnismäßig geringe Plasmadichten realisieren.

Es ist bekannt und aus verschiedenen technologischen Gründen häufig erforderlich, zur Erzeugung hoher Plasmadichten Bogenentladungs-Plasmaquellen zu verwenden (EP 0 545 863 B1; EP 0 666 933 B1). Wegen der räumlichen Begrenzung derartiger Bogenentladungen müssen zur Beschichtung großer Flächen die Substrate über die Beschichtungseinrichtung bewegt werden und mehrere Bogenentladungs-Plasmaquellen senkrecht zur Bewegungsrichtung der Substrate nebeneinander angeordnet werden.

Es ist weiterhin bekannt, zur Vergrößerung der Plasmaausdehnung in Bewegungsrichtung der Substrate ein in Bewegungsrichtung der Substrate und parallel zur Achse der Plasmaquellen ausgerichtetes Magnetfeld zu verwenden (EP 0 545 863 B1; EP 0 666 933 B1; DE 196 12 344 C1; DE 196 12 345 C1). Dieses Magnetfeld dient außerdem zur Erhöhung der Plasmadichte in der Nähe der Substratoberfläche und im Falle der Elektronenstrahlbedampfung zur Entkopplung des Bogenentladungs-Plasmas von dem für die Verdampfung erforderlichen hochenergetischen Elektronenstrahl.

Das Nebeneinander-Anordnen mehrerer Bogenentladungs-Plasmaquellen senkrecht zur Bewegungsrichtung der großflächigen Substrate führt zwangsläufig zu einer gewissen Ungleichmäßigkeit der Plasmadichte senkrecht zur Bewegungsrichtung der Substrate. Es wurde daher vorgeschlagen, mittels magnetischer Wechselfelder eine horizontale Wechselablenkung des Bogenplasmas zu bewirken und damit die Gleichmäßigkeit des Plasmas senkrecht zur Bewegungsrichtung der Substrate zu verbessern. Obwohl auf diese Weise im zeitlichen Mittel eine wesentliche Erhöhung der Gleichmäßigkeit des Plasmas erzielt werden kann, müssen bei hohen Beschichtungsraten und hohen Transportgeschwindigkeiten sehr hohe Wechselablenkfrequenzen verwendet werden, um unerwünschte Schwankungen der Schichteigenschaften in Bewegungsrichtung der Substrate oder in Richtung der Oberflächennormalen zu vermeiden. Das erfordert relativ kostenaufwendige Lösungen für die Wechselablenksysteme, zumal für eine optimale Gleichmäßigkeit spezielle zeitliche Ablenkprogramme erforderlich sind.

Aufgabe der Erfindung ist es, eine Einrichtung zur plasmaaktivierten Bedampfung großer Flächen zu schaffen, mit der auf einfache und kostengünstige Weise ein Plasma mit hoher Plasmadichte und eine hohe Gleichmäßigkeit des Plasmas senkrecht zur Bewegungsrichtung der Substrate erzeugt wird.

Erfindungsgemäß wird die Aufgabe nach den Merkmalen des Patentanspruches 1 gelöst. Vorteilhafte Ausgestaltungen der Erfindung sind in den Ansprüchen 2 bis 20 beschrieben.

In einem bekannten Vakuumrezipienten, der über ein Pumpensystem evakuierbar ist, befindet sich mindestens ein Verdampfer, mindestens eine Vorrichtung zur Halterung und zum Transport der zu beschichtenden Substrate und mindestens eine Plasmaquelle. Als Plasmaquellen kommen Bogenentladungs-Plasmaquellen zum Einsatz. Diese erzeugen einen hohen Anteil an gerichteten Niedervoltelektronen, die ohne Einwirkung äußerer Magnetfelder annähernd parallel zur Achse der Bogenentladungs-Plasmaquelle verlaufen.

Erfindungsgemäß wird die mindestens eine magnetfelderzeugende Einrichtung derart angeordnet, dass sich ein Magnetfeld ausbildet, dessen Feldlinien annähernd senkrecht zur Bewegungsrichtung und annähernd parallel zur Transportebene der Substrate verlaufen. Die mindestens eine Bogenentladungs-Plasmaquelle wird so angeordnet, dass deren Achse annähernd senkrecht zu den Feldlinien des Magnetfeldes ausgerichtet ist. Vorzugsweise ist die Achse mindestens einer Bogenentladungs-Plasmaquelle parallel zur Transportebene der Substrate ausgerichtet. Durch das Magnetfeld mit einer Feldrichtung senkrecht zur Achse der mindestens einen Bogenentladungs-Plasmaquelle breiten sich die gerichteten Niedervoltelektronen der Bogenentladung ebenfalls senkrecht zur Achse der Bogenentladungs-Plasmaquelle aus. Das ist dadurch bedingt, dass die Niedervoltelektronen mit einer typischen Energie von 10 eV in einem Magnetfeld mit einer typischen Feldstärke von 1 kA/m mit einem Radius von ca. 1 cm umgelenkt werden und sich mit diesem Radius quasi um die senkrecht zur Plasmaquelle verlaufenden Magnetfeldlinien wickeln und einen Plasmaschlauch bilden. Bei den bisher bekannten Lösungen mit dem in Richtung der Plasmaquellen-Achse verlaufenden Magnetfeldlinien wurde dieser Effekt genutzt, um das Plasma in Plasmaquellen-Richtung zu bündeln und damit eine hohe Plasmadichte und eine groBe Reichweite des Plasmastrahls zu erzielen. Entsprechend der vorliegenden Erfindung verlaufen die Magnetfeldlinien annähernd senkrecht zur Plasmaquellen-Achse, so dass sich der Plasmaschlauch ebenfalls senkrecht zur Achse der mindestens einen Plasmaquelle ausbreitet, wobei sich auch in Bereichen des Plasmaschlauches, der nicht unmittelbar vor den Bogenentladungs-Plasmaquellen liegt, ein gleichmäßiges Plasma ausbildet. Dadurch wird bei einer Nebeneinanderanordnung mehrerer Plasmaquellen auch ohne die aufwendige Wechseiablenkung eine hohe Gleichmäßigkeit des Plasmas über die gesamte Substratbreite erzielt.

Eine entsprechende Gleichmäßigkeit des Dampfstromes für die Beschichtung der bewegten Substrate wird in an sich bekannter Weise dadurch erzielt, dass sich ein Großflächenverdampfer oder eine Reihe von nebeneinander angeordneten Kleinflächenverdampfem über die gesamte Substratbreite erstreckt. Im Falle der Elektronenstrahlverdampfung kann die Steuerung der Dampfdichteverteilung über die Substratbreite durch die programmierte Ablenkung eines oder mehrerer Elektronenstrahlen, die in einer oder in mehreren parallel nebeneinander angeordneten Axial-Elektronenkanonen erzeugt werden, erfolgen.

Es hat sich als vorteilhaft erwiesen, für die Erzeugung des Plasmas Hohlkathoden-Bogenentladungsquellen zu verwenden. Die Plasmaquellen werden parallel nebeneinander mit einem seitlichen Abstand von vorzugsweise 100 bis 300 mm angeordnet, wobei die Achsen der Plasmaquellen in Bewegungsrichtung der Substrate ausgerichtet sind.

Besonders vorteilhaft ist es, wenn jeder Hohlkathoden-Bogenentladungsquelle eine Anode zugeordnet wird, die entweder auf der der Hohlkathode gegenüberliegenden Seite der Bedampfungszone oder als Ringanode unmittelbar vor der jeweiligen Hohlkathode angeordnet ist. Die Anordnung auf der gegenüberliegenden Seite der Bedampfungszone hat den Vorteil, dass trotz der Ausrichtung der Magnetfeldlinien senkrecht zur Bewegungsrichtung des Substrates die Plasmaelektronen durch die Bedampfungszone hindurch auf die gegenüberliegenden Anoden gezogen werden, so dass eine lonisierung der gesamten Bedampfungszone erfolgt. Für bestimmte Anwendungen, beispielsweise für die Herstellung von Gradientenschichten, kann es vorteilhaft sein, wenn die Plasmaaktivierung nur an der Einlaufseite der Substrate in die Bedampfungszone erfolgt, und an der Auslaufseite keine oder nur eine geringe Plasmaaktivierung erfolgt. In diesem Fall wird die Anordnung ringförmiger Anoden unmittelbar vor den Hohlkathoden empfohlen, wobei sich ein Plasmaschlauch im Bereich der Austrittsöffnungen der Hohlkathoden senkrecht zur Transportrichtung der Substrate und senkrecht zu den Achsen der Hohlkathoden ausbildet.

Es kann auch vorteilhaft sein, durch Verwendung von ringförmigen Anoden unmittelbar vor den Hohlkathoden zunächst einen Plasmaschlauch quer zur Bewegungsrichtung der Substrate zu erzeugen und jeder ringförmigen Anode eine zweite Anode zuzuordnen, die ein positives Potential gegenüber der jeweiligen ringförmigen Anode aufweist. Diese zweiten Anoden können sowohl auf der den Hohlkathoden gegenüberliegenden Seite der Bedampfungszone als auch im Bereich der Verdampferoberfläche angeordnet sein. Bei Anordnung auf der den Hohlkathoden gegenüberliegenden Seite wird wie bei Betrieb ohne Ringanode eine gleichmäßige lonisierung über die gesamte Bedampfungszone erreicht. Bei Anordnung der zweiten Anoden im Bereich der Verdampferoberfläche wird in bereits bekannter Weise ein Potentialgefälle in Dampfausbreitungsrichtung erzeugt, welches zu einer zusätzlichen Beschleunigung von Ionen auf das Substrat und damit zu verbesserten Schichteigenschaften führt. Die zweiten Anoden können in bekannter Weise (DE 100 18 639 C1) auch zum Einlassen von Reaktivgasen für die plasmaaktivierte reaktive Bedampfung genutzt werden.

Eine Möglichkeit zur Verlagerung des Plasmaschlauches, d. h. eine Verlagerung der Zone der maximalen Plasmaaktivierung, von der Öffnung der Hohlkathoden in Richtung auf die Mitte der Bedampfungszone besteht darin, das Magnetfeld im Bereich der Hohlkathodenöffnungen durch magnetische Kompensationsspulen so weit zu schwächen, dass die aus den Hohlkathodenöffnungen austretenden Niedervoltelektronen sich zunächst in Richtung der Hohlkathodenachsen ausbreiten, bevor sie durch das stärker werdende Magnetfeld auf Schraubenbahnen entlang der quer verlaufenden Magnetfeldlinien gezwungen werden.

Eine andere Möglichkeit zur Verlagerung des Plasmaschlauches von der Öffnung der Hohlkathoden in Richtung auf die Mitte der Bedampfungszone besteht darin, jede Hohlkathode mit einer koaxialen Magnetspule zu umgeben und dadurch ein zur Hohlkathodenachse paralleles Magnetfeld zu erzeugen, das die aus der Hohlkathode austretenden Niedervoltelektronen in Richtung der Hohlkathodenachse bündelt, so dass die Ausbildung des Plasmaschlauches senkrecht zu den Hohlkathodenachsen erst in größerer Entfernung von den Hohlkathodenöffnungen, d. h. außerhalb des Bereiches des zur Hohlkathodenachse parallelen Magnetfeldes, erfolgt.

Im Falle der Elektronenstrahlverdampfung kann das senkrecht zur Bewegungsrichtung der Substrate ausgerichtete Magnetfeld außer zur Vergleichmäßigung des Plasmas in an sich bekannter Weise auch zur Umlenkung des für die Verdampfung benötigten Elektronenstrahls auf die Oberfläche des Verdampfungsgutes genutzt werden. Dabei ist es zweckmäßig, die Geometrie und die Feldstärke des Magnetfeldes so zu bemessen, dass der über die Verdampferbreite abgelenkte Elektronenstrahl in jeder Ablenkphase unter einem Winkel zwischen Null und 60° gegen die Oberflächennormale auf die Verdampferoberfläche auftrifft.

Die Erzeugung des senkrecht zur Bewegungsrichtung der Substrate angeordneten Magnetfeldes kann durch zwei Magnetpolschuhe erfolgen, die in Bewegungsrichtung der Substrate gesehen seitlich der Bedampfungszone angeordnet sind.

Das Magnetfeld kann auch durch eine lange Magnetspule erzeugt werden, deren Länge größer als die Breite der bewegten Substrate ist, und deren Achse senkrecht zur Bewegungsrichtung der Substrate und parallel zur Transportebene der Substrate ausgerichtet ist. Es ist vorteilhaft, wenn die lange Magnetspule mit einem ferromagnetischen Spulenkem versehen ist. Zur Beeinflussung der Plasmadichteverteilung senkrecht zur Bewegungsrichtung der Substrate und/oder Erzielung weitgehend gleicher Auftreffwinkel des Elektronenstrahls auf die Verdampferoberfläche im Falle der Elektronenstrahlverdampfung ist es zweckmäßig, die Verteilung von Richtung und Stärke des Magnetfeldes über die Beschichtungsbreite entsprechend anzupassen. Das kann durch Variation der Windungszahl pro Spulenlänge entlang der Spulenachse erfolgen. Es kann auch dadurch erfolgen, dass die Magnetspule aus mehreren in axialer Richtung aneinandergereihten Teilspulen besteht, wobei die Ströme in den einzelnen Teilspulen unterschiedlich eingestellt werden. Es hat sich als zweckmäßig erwiesen, die Windungszahl pro Spulenlänge bzw. die Ströme durch die Teilspulen an den Spulenenden größer zu wählen als in Spulenmitte.

An einem Ausführungsbeispiel soll die Erfindung näher erläutert werden. Die zugehörigen Zeichnungen zeigen die Seitenansicht und die Draufsicht auf eine erfindungsgemäße Einrichtung.

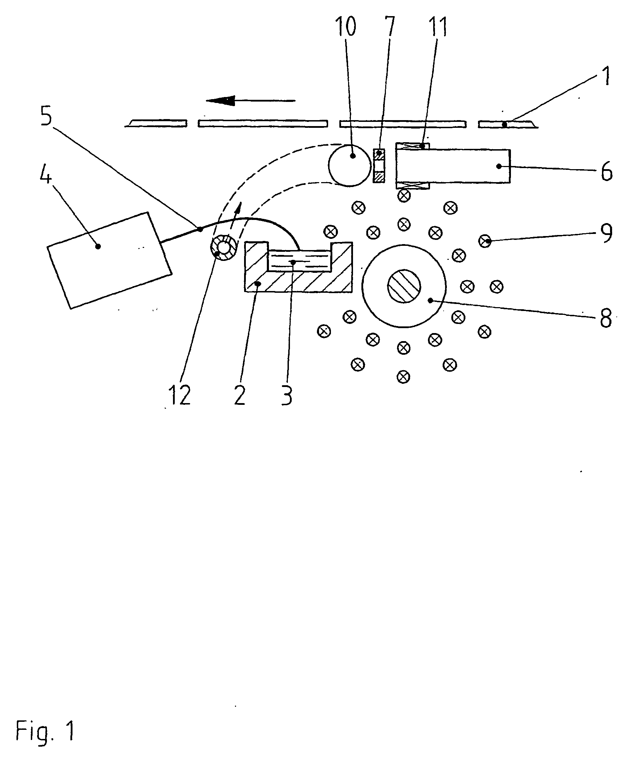

Fig. 1 zeigt in der Seitenansicht die zu beschichtenden großflächigen Substrate 1, beispielsweise 2 m breite Kunststoffplatten, die durch ein nicht dargestelltes Transportsystem mit konstanter Geschwindigkeit von rechts nach links über die Beschichtungseinrichtung geführt werden. Das in einem Verdampfertiegel 2 befindliche Verdampfungsmaterial 3, beispielsweise Aluminium, wird durch den in einer Axial-Elektronenkanone 4 erzeugten Elektronenstrahl 5 aufgeheizt und zum Verdampfen gebracht. Als Plasmaquelle 6 dient eine Hohlkathoden-Bogenentladungsquelle, deren Achse annähernd parallel zur Bewegungsrichtung der Substrate 1 ausgerichtet ist. Die Hohlkathoden-Bogenentladung brennt zwischen der Hohlkathode im Inneren der Plasmaquelle 6 und der unmittelbar vor der Hohlkathodenöffnung angeordneten ringförmigen Anode 7. Die durch die Öffnung der ringförmigen Anode hindurchtretenden Niedervoltelektronen werden durch das von einer Magnetspule 8 erzeugte, senkrecht zur Achse der Plasmaquelle 6 und senkrecht zur Bewegungsrichtung der Substrate 1 ausgerichtete Magnetfeld 9 auf Kreisbahnen gezwungen und bilden unmittelbar hinter der ringförmigen Anode 7 einen Plasmaschlauch 10 senkrecht zur Bewegungsrichtung der Substrate 1. Dieser Plasmaschlauch 10 kann in größerem Abstand von der ringförmigen Anode 7, beispielsweise mittig über dem Verdampfertiegel 2 erzeugt werden, wenn durch zur Hohlkathode axiale Magnetspulen 11 in der Nähe der Hohlkathodenöffnung ein zur Hohlkathodenachse paralleles Magnetfeld erzeugt wird, das die Niedervoltelektronen zunächst axial bündelt, bevor sie in größerer Entfernung von der Hohlkathodenöffnung durch das zur Hohlkathodenachse senkrechte Magnetfeld 9 auf Kreisbahnen gezwungen werden. Durch eine zweite Anode 12, die sich gegenüber der ringförmigen Anode 7 auf einem um etwa +30 V höherem Potential befindet, kann eine Sekundärentladung zwischen dem Plasmaschlauch 10 und der zweiten Anode 12 gezündet werden. Bei Entladungsströmen der Sekundärentladung von etwa 100 A erfolgt eine starke lonisierung des verdampften Materials. Die dabei gebildeten lonen werden durch das vertikale Potentialgefälle zwischen ringförmiger Anode 7 und zweiter Anode 12 in Richtung auf das Substrat 1 beschleunigt und führen zu einer erhöhten Dichte der kondensierenden Schicht. Für die reaktive Beschichtung der Substrate 1, beispielsweise für das Abscheiden von Aluminiumoxid beim Verdampfen von metallischem Aluminium, kann durch Düsen in der zweiten Anode 12 ein Reaktivgas, beispielsweise Sauerstoff, in die Bedampfungszone eingelassen werden. Durch die Sekundärentladung zwischen ringförmiger Anode 7 und zweiter Anode 12 wird dieses Reaktivgas angeregt und ionisiert, so dass dessen Reaktivität wesentlich erhöht wird.

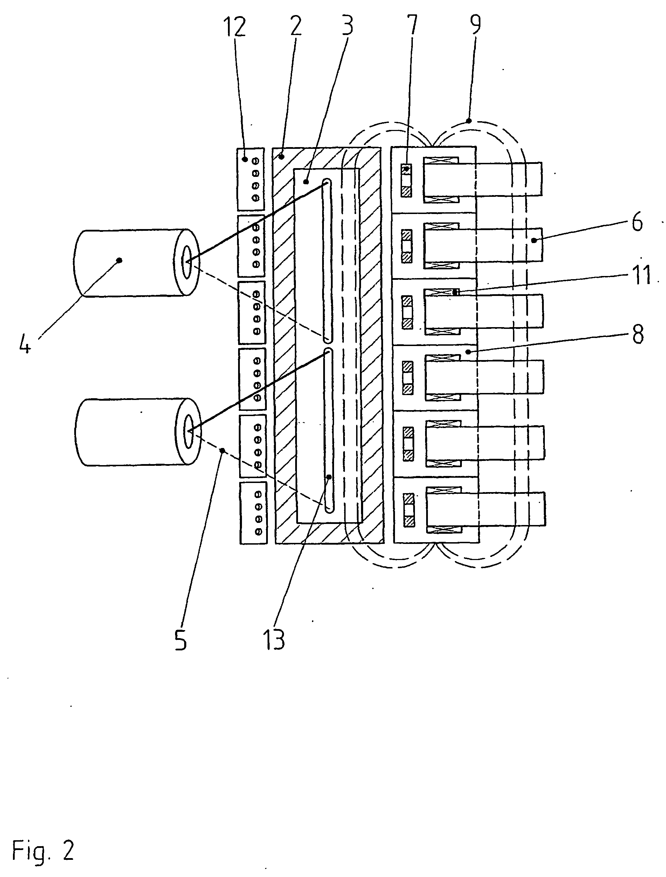

Fig. 2 zeigt die gleiche Anordnung in der Draufsicht. Für die Beschichtung der etwa 2 m breiten, hier nicht dargestellten Substrate 1 wird ein Verdampfertiegel 2 von etwa 2,5 m Breite benötigt, auf dem durch programmierte seitliche Ablenkung der in zwei Axial-Elektronenkanonen 4 erzeugten Elektronenstrahlen 5 zwei aneinander anschließende Ablenklinien 13 von je etwa 1,1 m Länge generiert werden. Die Verweilzeit der Elektronenstrahlen 5 an den einzelnen Punkten der Ablenklinien 13 wird so programmiert oder geregelt, dass die Dicke der auf die Substrate 1 aufgedampften Schicht über die gesamte Beschichtungsbreite annähernd konstant ist. Das durch die Magnetspule 8 erzeugte, zur Achse der Elektronenkanonen 4 und der Plasmaquellen 6 annähernd senkrechte Magnetfeld 9 dient außer zur Führung der Niedervoltelektronen des Plasmas auch zur Umlenkung der Elektronenstrahlen 5 auf die Oberfläche des Verdampfungsmaterials 3 (vgl. Fig. 1). Die Geometrie und die Stärke dieses Magnetfeldes 9 wird so eingestellt, dass die Elektronenstrahlen 5 für jeden Punkt der Ablenklinien 13 unter einem möglichst kleinen Winkel gegen die Oberflächennormale auf das Verdampfungsmaterial 3 auftreffen. Aus diesem Grund ist im vorliegenden Beispiel die Magnetspule 8 in 6 Teilspulen untergliedert, die mit unter-schiedlichen Spulenströmen beaufschlagt werden können. Auf diese Weise ist es möglich, die Magnetfeldstärke und damit den Umlenkwinkel der Elektronenstrahlen 5 für jeden Punkt der Ablenklinien 13 in der gewünschten Weise einzustellen.

## Patentansprüche

1. Einrichtung zur plasmaaktivierten Bedampfung großflächiger bewegter Substrate (1), mindestens enthaltend einen Vakuumrezipienten, ein Pumpsystem, einen Verdampfer (2), eine Vorrichtung zur Halterung und zum Transport der zu beschichtenden Substrate (1) und mindestens eine Bogenentladungs-Plasmaquelle, **dadurch gekennzeichnet, dass** mindestens eine magnetfelderzeugende Einrichtung (8) enthalten ist, die in der Bedampfungszone zwischen dem Verdampfer (2) und dem Substrat (1) ein Magnetfeld (9) erzeugen kann, dessen Feldlinien annähernd senkrecht zur Bewegungsrichtung und parallel zur Transportebene des Substrates (1) ausgerichtet sind und mindestens eine Bogenentladungs-Plasmaquelle so angeordnet ist, dass die Austrittsrichtung der Ladungsträger einer Bogenentladung aus der Bogenentladungs-Plasmaquelle annähernd senkrecht zu den Feldlinien des Magnetfeldes (9) ausgerichtet ist.

2. Einrichtung nach Anspruch 1, **dadurch gekennzeichnet, dass** mindestens eine Bogenentladungs-Plasmaquelle so angeordnet ist, dass die Austrittsrichtung der Ladungsträger einer Bogenentladung aus der Bogenentladungs-Plasmaquelle annähernd parallel zur Transportebene der Substrate ausgerichtet ist.

3. Einrichtung nach Anspruch 1 oder 2, **dadurch gekennzeichnet, dass** als Substrate (1) linear bewegte Bänder, Platten oder auf Transportrahmen angeordnete Formkörper vorgesehen sind.

4. Einrichtung nach einem der Ansprüche 1 bis 3, **dadurch gekennzeichnet, dass** sich der Verdampfer senkrecht zur Bewegungsrichtung und parallel zur Transportebene der Substrate über die gesamte Substratbreite erstreckt und dass ein einziger langgestreckter Großflächenverdampfer (2) oder eine Reihe nebeneinander angeordneter Kleinflächenverdampfer vorgesehen sind.

5. Einrichtung nach einem der Ansprüche 1 bis 4, **dadurch gekennzeichnet, dass** als Verdampfer Elektronenstrahlverdampfer vorgesehen sind, wobei eine oder mehrere Axial-Elektronenkanonen (4) parallel nebeneinander und mit ihren Achsen annähernd parallel zur Bewegungsrichtung der Substrate (1) angeordnet sind, und dass Mittel zur programmierten Ablenkung der Elektronenstrahlen (5) senkrecht zur Transportrichtung der Substrate (1) vorgesehen sind.

6. Einrichtung nach einem der Ansprüche 1 bis 5, **dadurch gekennzeichnet, dass** als Bogenentladungs-Plasmaquellen Hohlkathoden-Bogenentladungsquellen (6) vorgesehen sind.

7. Einrichtung nach Anspruch 6, **dadurch gekennzeichnet, dass** mehrere Hohlkathoden-Bogenentladungsquellen (6) parallel nebeneinander und mit ihren Achsen annähernd parallel zur Bewegungsrichtung der Substrate (1) angeordnet sind.

8. Einrichtung nach einem der Ansprüche 6 oder 7, **dadurch gekennzeichnet, dass** die Anoden der Hohlkathoden-Bogenentladungsquellen (6) auf der den Hohlkathoden gegenüberliegenden Seite der Bedampfungszone angeordnet sind.

9. Einrichtung nach einem der Ansprüche 6 oder 7, **dadurch gekennzeichnet, dass** die Anoden (7) der Hohlkathoden-Bogenentladungsquellen (6) ringförmig ausgebildet und unmittelbar vor den Plasma-Austrittsöffnungen der Hohlkathoden angeordnet sind.

10. Einrichtung nach Anspruch 9, **dadurch gekennzeichnet, dass** für jede Hohlkathoden-Bogenentladungsquelle (6) eine zweite Anode (12) vorgesehen ist, die ein positives Potential gegenüber der zugehörigen ringförmigen Anode (7) besitzt und die in der Nähe der Verdampferoberfläche angeordnet ist.

11. Einrichtung nach mindestens einem der Ansprüche 6 bis 10, **dadurch gekennzeichnet, dass** magnetische Kompensationsspulen enthalten sind, deren Magnetfeld dafür sorgt, dass das annähernd senkrecht zur Bewegungsrichtung der Substrate ausgerichtete Magnetfeld im Bereich der Plasma-Austrittsöffnungen der Hohlkathoden verringert wird.

12. Einrichtung nach mindestens einem der Ansprüche 6 bis 11, **dadurch gekennzeichnet, dass** zu den Hohlkathoden koaxiale Magnetspulen (11) enthalten sind, deren Magnetfeld dafür sorgt, dass im Bereich der Plasma-Austrittsöffnungen der Hohlkathoden ein zu den Hohlkathodenachsen annähernd paralleles Magnetfeld vorhanden ist.

13. Einrichtung nach mindestens einem der Ansprüche 1 bis 12, **dadurch gekennzeichnet, dass** das annähernd senkrecht zur Bewegungsrichtung und parallel zur Transportebene der Substrate ausgerichtete Magnetfeld (9) bezüglich Magnetfeldstärke und Geometrie so bemessen ist, dass im Falle der Elektronenstrahlverdampfung die in den Elektronenkanonen (4) erzeugten und über die gesamte Verdampferbreite abgelenkten Elektronenstrahlen unter einem Winkel zwischen Null und 60° gegen die Oberflächennormale auf die Verdampferoberfläche auftreffen.

14. Einrichtung nach mindestens einem der Ansprüche 1 bis 13, **dadurch gekennzeichnet, dass** zur Erzeugung des annähernd senkrecht zur Bewegungsrichtung und parallel zur Transportebene der Substrate ausgerichteten Magnetfeldes zwei Magnetpolschuhe vorgesehen sind, die in Bewegungsrichtung der Substrate gesehen seitlich der Bedampfungszone angeordnet sind.

15. Einrichtung nach mindestens einem der Ansprüche 1 bis 13, **dadurch gekennzeichnet, dass** zur Erzeugung des annähernd senkrecht zur Bewegungsrichtung der Substrate ausgerichteten Magnetfeldes eine Magnetspule vorgesehen ist, deren Länge größer als die Breite der bewegten Substrate ist, und deren Achse senkrecht zur Bewegungsrichtung und parallel zur Transportebene der Substrate ausgerichtet ist.

16. Einrichtung nach Anspruch 15, **dadurch gekennzeichnet, dass** die Magnetspule entlang ihrer Achse einen ferromagnetischen Spulenkern besitzt.

17. Einrichtung nach den Ansprüchen 15 und 16, **dadurch gekennzeichnet, dass** die Windungszahl pro Spulenlänge entlang der Spulenachse unterschiedlich ist.

18. Einrichtung nach Anspruch 17, **dadurch gekennzeichnet, dass** die Windungszahl pro Spulenlänge an den Spulenenden größer als in Spulenmitte ist.

19. Einrichtung nach den Ansprüchen 15 und 16, **dadurch gekennzeichnet, dass** die Magnetspule aus mehreren in axialer Richtung aneinandergereihten Teilspulen besteht, wobei die Ströme in den einzelnen Teilspulen unterschiedlich eingestellt werden können.

20. Einrichtung nach Anspruch 19, **dadurch gekennzeichnet, dass** die Ströme durch die äußeren Teilspulen größer eingestellt sind als die Ströme durch die inneren Teilspulen.

## Revendications

1. Dispositif pour mettre en oeuvre une métallisation sous vide activée par plasma sur des substrats de grande surface en mouvement (1), contenant au moins un récipient sous vide, un système de pompe, un évaporateur (2), un dispositif pour maintenir et pour transporter les substrats à revêtir (1) et au moins une source de plasma à décharge d'arc,
**caractérisé en ce qu'**
il contient au moins un dispositif (8) de production de champ magnétique, qui peut produire dans la zone de métallisation entre l'évaporateur (2) et le substrat (1), un champ magnétique (9) dont les lignes de champ sont orientées sensiblement perpendiculairement à la direction de mouvement et parallèlement au plan de transport du substrat (1), et au moins une source de plasma à décharge d'arc est disposée de telle manière que la direction de sortie des porteurs de charge d'une décharge d'arc hors de la source de plasma à décharge d'arc soit orientée sensiblement perpendiculairement aux lignes de champ du champ magnétique (9).

2. Dispositif selon la revendication 1,
**caractérisé en ce qu'**
au moins une source de plasma à décharge d'arc est disposée de telle manière que la direction de sortie des porteurs de charge d'une décharge d'arc hors de la source de plasma à décharge d'arc soit orientée sensiblement parallèlement au plan de transport des substrats.

3. Dispositif selon la revendication 1 ou 2,
**caractérisé en ce que**
comme substrats (1) des bandes, des plaques ou des corps moulés sont disposés sur des cadres de transport en mouvement linéaire.

4. Dispositif selon l'une quelconque des revendications 1 à 3,
**caractérisé en ce que**
l'évaporateur s'étend perpendiculairement à la direction de mouvement et parallèlement au plan de transport des substrats, sur toute la largeur des substrats, et on prévoit un évaporateur allongé de grande surface (2) ou une série d'évaporateurs de petite surface juxtaposés.

5. Dispositif selon l'une quelconque des revendications 1 à 4,
**caractérisé en ce que**
les évaporateurs sont des évaporateurs à faisceaux d'électrons, avec un ou plusieurs canons à électrons (4) juxtaposés axialement et parallèles, et dont les axes sont sensiblement parallèles à la direction de mouvement des substrats (1), et des moyens sont prévus pour la déviation programmée des faisceaux d'électrons (5) perpendiculairement à la direction de transport des substrats (1).

6. Dispositif selon l'une quelconque des revendications 1 à 5,
**caractérisé en ce que**
les sources de plasma à décharge d'arc sont des sources à décharge d'arc à cathode creuse (6).

7. Dispositif selon la revendication 6,
**caractérisé en ce que**
plusieurs sources à décharge d'arc à cathode creuse (6) sont parallèles l'une à l'autre et avec leurs axes approximativement parallèlement à la direction de mouvement des substrats (1).

8. Dispositif selon l'une des revendications 6 ou 7,
**caractérisé en ce que**
les anodes des sources à décharge d'arc à cathode creuse (6) sont disposées sur le côté de la zone de métallisation opposé aux cathodes creuses.

9. Dispositif selon l'une des revendications 6 ou 7,
**caractérisé en ce que**
les anodes (7) des sources à décharge d'arc à cathode creuse (6) sont annulaires et disposées immédiatement devant les ouvertures de sortie du plasma des cathodes creuses.

10. Dispositif selon la revendication 9,
**caractérisé en ce que**
pour chaque source à décharge de plasma à cathode creuse (6), une deuxième anode (12), qui présente un potentiel positif par rapport à l'anode annulaire associée (7), est disposée à proximité de la surface d'évaporateur.

11. Dispositif selon au moins une des revendications 6 à 10,
**caractérisé par**
des bobines de compensation magnétiques, dont le champ magnétique assure que le champ magnétique orienté sensiblement perpendiculairement à la direction de mouvement des substrats est réduit dans la région des ouvertures de sortie du plasma des cathodes creuses.

12. Dispositif selon au moins une des revendications 6 à 11,
**caractérisé par**
il est prévu des bobines magnétiques (11) coaxiales aux cathodes creuses, dont le champ magnétique assure un champ magnétique sensiblement parallèle aux axes des cathodes creuses dans la région des ouvertures de sortie du plasma des cathodes creuses.

13. Dispositif selon au moins une des revendications 1 à 12,
**caractérisé en ce que**
le champ magnétique (9) sensiblement perpendiculaire à la direction de mouvement et parallèle au plan de transport des substrats est défini, en termes d'intensité de champ magnétique et de géométrie, de telle façon que, dans le cas de l'évaporation par des faisceaux d'électrons, les faisceaux d'électrons produits dans les canons à électrons (4) et déviés sur toute la largeur d'évaporateur frappent la surface d'évaporateur sous un angle compris entre zéro et 60° par rapport à la normale à la surface.

14. Dispositif selon au moins une des revendications 1 à 13,
**caractérisé en ce que**
pour la production du champ magnétique sensiblement perpendiculaire à la direction de mouvement et parallèle au plan de transport des substrats, deux masses polaires magnétiques sont disposées latéralement par rapport à la zone de métallisation vue dans la direction de mouvement des substrats.

15. Dispositif selon au moins une des revendications 1 à 13,
**caractérisé en ce que**
pour la production du champ magnétique sensiblement perpendiculaire à la direction de mouvement des substrats, une bobine magnétique dont la longueur est plus grande que la largeur des substrats en mouvement, a son axe perpendiculaire à la direction de mouvement et parallèle au plan de transport des substrats.

16. Dispositif selon la revendication 15,
**caractérisé en ce que**
la bobine magnétique possède le long de son axe un noyau de bobine ferromagnétique.

17. Dispositif selon les revendications 15 et 16,
**caractérisé en ce que**
le nombre de spires par unité de longueur de la bobine est différent le long de l'axe de la bobine.

18. Dispositif selon la revendication 17,
**caractérisé en ce que**
le nombre de spires par unité de longueur de la bobine est plus grand aux extrémités de la bobine qu'au milieu de la bobine.

19. Dispositif selon les revendications 15 et 16,
**caractérisé en ce que**
la bobine magnétique se compose de plusieurs bobines partielles alignées en direction axiale, dont les courants peuvent être réglés de manière différente dans les bobines partielles respectives.

20. Dispositif selon la revendication 19,
**caractérisé en ce que**
les courants circulant dans les bobines partielles externes sont plus élevés que les courants circulant dans les bobines partielles internes.

## Claims

1. A device for plasma activated vacuum depositing of large area moved substrates (1), containing at least one vacuum recipient, a pump system, an evaporator (2), a device for supporting and transporting the substrate (1) to be coated and at least one arc discharge plasma source, **characterised in that** at least one magnetic field generating device (8) is contained which is able to generate, in the vacuum depositing zone between the evaporator (2) and the substrate (1), a magnetic field (9) whose field lines are aligned approximately perpendicularly to the direction of movement and parallel with the plane of transport of the substrate (1), and **in that** at least one arc discharge plasma source is arranged so that the direction of escape of the charge carrier of an arc discharge from the arc discharge plasma source is aligned approximately perpendicularly to the field lines of the magnetic field (9).

2. The device according to Claim 1, **characterised in that** at least one arc discharge plasma source is arranged so that the direction of escape of the charge carrier of an arc discharge from the arc discharge plasma source is aligned approximately parallel with the plane of transport of the substrate.

3. The device according to Claim 1 or 2, **characterised in that** strips, plates or moulded elements that are moved linearly are provided as substrates (1).

4. The device according to one of Claims 1 to 3, **characterised in that** the evaporator extends perpendicularly to the direction of movement and parallel with the plane of transport of the substrates over the entire substrate width, and **in that** a single elongated large area evaporator (2) or a series of small area evaporators arranged adjacent to each other are provided.

5. The device according to Claims 1 to 4, **characterised in that** electron beam evaporators are provided as evaporators, wherein one or more axial electron guns (4) are arranged parallel with each other and, with their axes, approximately parallel with the direction of movement of the substrates (1), and **in that** means are provided for the programmed deflection of the electron beams (5) perpendicular to the direction of transport of the substrates (1).

6. The device according to one of Claims 1 to 5, **characterised in that** hollow cathode arc discharge sources (6) are provided as arc discharge plasma sources.

7. The device according to Claim 6, **characterised in that** several hollow cathode arc discharge sources (6) are arranged parallel with each other and, with their axes, approximately parallel with the direction of movement of the substrates (1).

8. The device according to one of Claims 6 or 7, **characterised in that** the anodes of the hollow cathode arc discharge sources (6) are arranged on the side of the vacuum depositing zone opposite the hollow cathodes.

9. The device according to one of Claims 6 or 7, **characterised in that** the anodes (7) of the hollow cathode arc discharge sources (6) are of an annular design and are arranged immediately in front of the plasma outlet ports of the hollow cathodes.

10. The device according to Claim 9, **characterised in that** a second anode (12) is provided for each hollow cathode arc discharge source (6), which anode exhibits a positive potential opposite the associated annular anode (7) and which is arranged in the vicinity of the evaporator surface.

11. The device according to at least one of Claims 6 to 10, **characterised in that** magnetic compensating coils are incorporated whose magnetic field ensures that the magnetic field aligned approximately perpendicularly to the direction of movement of the substrates is reduced in the region of the plasma outlet ports of the hollow cathodes.

12. The device according to at least one of Claims 6 to 11, **characterised in that** magnetising coils (11) coaxial with the hollow cathodes are incorporated whose magnetic field ensures that a magnetic field approximately parallel with the hollow cathode axes is provided in the region of the plasma outlet ports.

13. The device according to at least one of Claims 1 to 12, **characterised in that** the magnetic field (9) aligned approximately perpendicularly to the direction of movement and parallel with the plane of transport of the substrates is dimensioned in relation to the magnetic field strength and geometry in such a manner that in the case of electron beam evaporation the electron beams generated in the electron guns (4) and deflected throughout the evaporator width strike the evaporator surface at an angle between zero and 60° to the surface perpendicular.

14. The device according to at least one of Claims 1 to 13, **characterised in that** two magnetic pole shoes are provided for generating the magnetic field aligned approximately perpendicularly to the direction of movement and parallel with the plane of transport of the substrates, which shoes are arranged in the direction of movement of the substrates viewed to the side of the vacuum depositing zone.

15. The device according to at least one of Claims 1 to 13, **characterised in that** a magnetising coil, whose length is greater than the width of the moved substrate and whose axis is aligned perpendicularly o the direction of movement and parallel with the plane of transport of the substrates, is provided for generating the magnetic field aligned approximately perpendicularly to the direction of movement of the substrates.

16. The device according to Claim 15, **characterised in that** the magnetising coil exhibits a ferromagnetic coil core along its axis.

17. The device according to Claims 15 and 16, **characterised in that** the number of windings per coil length along the coil axis is different.

18. The device according to Claim 17, **characterised in that** the number of windings per coil length is greater at the coil ends than at the coil centre.

19. The device according to Claims 15 and 16, **characterised in that** the magnetising coil consists of several partial coils arranged one after the other in the axial direction, wherein the currents can be set differently in the individual partial coils.

20. The device according to Claim 19, **characterised in that** the currents flowing through the outer partial coils are set greater than the currents flowing through the inner partial coils.
